# EUROPEAN PATENT APPLICATION

(11) **EP 4 697 895 A1**
(43) Date of publication of application: **18.02.2026**
(21) Application number: 25194077.1
(22) Date of filing: 05.08.2025
(51) Int. Cl.: H10D 84/01, H10D 88/00, H10D 64/23, H10D 84/83

(54) **STACKED SEMICONDUCTOR DEVICE INCLUDING DIFFERENT SOURCE/DRAIN CONTACT STRUCTURES**

(30) Priority: 13.08.2024 US 202463682657 P; 31.03.2025 US 202519096036
(71) Applicant: SAMSUNG ELECTRONICS CO., LTD., Yeongtong-gu Suwon-si, Gyeonggi-do 16677 (KR)
(72) Inventor: PARK, Inwon, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Provided is a semiconductor device which includes: a 1^{st} source/drain pattern at a 1^{st} level; a 2^{nd} source/drain pattern at a 2^{nd} level vertically different from the 1^{st} level; and a 1^{st} contact structure on the 1^{st} source/drain pattern, wherein a portion of the 1^{st} source/drain pattern is in a 1^{st} recess of the 1^{st} contact structure.

## Description

### BACKGROUND

### 1. Field

Apparatuses and methods consistent with the disclosure relate to a stacked semiconductor device including a bottom isolation layer.

### 2. Description of Related Art

A stacked semiconductor device has been introduced in response to increased demand for an integrated circuit having high device density and performance. The stacked semiconductor device may include a 1^{st} transistor at a 1^{st} level and a 2^{nd} transistor at a 2^{nd} level vertically above the 1^{st} level, where each of the two transistors may be a fin field-effect transistor (FinFET), a nanosheet transistor, a forksheet transistor, or any other type of transistor.

The FinFET has one or more horizontally arranged vertical fin structures as a channel structure of which at least three surfaces are surrounded by a gate structure, and the nanosheet transistor is characterized by one or more nanosheet layers, which are vertically stacked or arranged on a substrate, as a channel structure and a gate structure surrounding all four surfaces of each of the nanosheet layers. The nanosheet transistor is referred to as gate-all-around (GAA) transistor, or as a multi-bridge channel field-effect transistor (MBCFET). The forksheet transistor is a combination of two nanosheet transistors with an isolation wall therebetween. Nanosheet layers of each nanosheet transistor are formed at each side of the isolation wall and pass through a gate structure in parallel with the isolation wall.

In addition to stacked semiconductor device, a backside power distribution network (BSPDN) for a semiconductor device has been introduced to address a heavy traffic of signal lines and power rails at a front side of the semiconductor device. The BSPDN may contribute to reducing contact resistance between circuit elements formed at the front side of the semiconductor device. Here, the front side refers to a side where a transistor is formed with respect to a top surface of a substrate, and the back side refers to a side opposite to the front side. The BSPDN is formed on a back side of a semiconductor device, and may include a backside metal line, such as a buried power rail, and a backside contact structure formed on a bottom surface of a source/drain pattern of a field-effect transistor such as a nanosheet transistor or a FinFET. The backside metal line may connect the backside contact structure to a voltage source or another circuit element for signal routing.

Still, however, the stacked semiconductor device with or without the BSPDN structure requires performance improvement in a variety of different ways.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides a stacked semiconductor device in which source/drain patterns and corresponding contact structures are formed to increase respective channel stresses to improve device performance.

According to an aspect of the disclosure, there is provided a stacked semiconductor device which may include: a 1^{st} source/drain pattern at a 1^{st} level; a 2^{nd} source/drain pattern at a 2^{nd} level vertically different from the 1^{st} level; and a 1^{st} contact structure on the 1^{st} source/drain pattern, wherein a portion of the 1^{st} source/drain pattern is in a 1^{st} recess of the 1^{st} contact structure.

According to an aspect of the disclosure, there is provided a stacked semiconductor device which may include: a 1^{st} source/drain pattern at a 1^{st} level; a 2^{nd} source/drain pattern at a 2^{nd} level vertically different from the 1^{st} level; and a 1^{st} contact structure on the 1^{st} source/drain pattern, wherein a portion of the 1^{st} contact structure is in a 1^{st} recess on the 1^{st} source/drain pattern.

According to an aspect of the disclosure, there is provided a stacked semiconductor device which may include: a 1^{st} source/drain pattern at a 1^{st} level; and a 2^{nd} source/drain pattern at a 2^{nd} level, vertically different from the 1^{st} level, wherein a top surface or a bottom surface of the 1^{st} source/drain pattern comprises a recess.

### BRIEF DESCRIPTION OF DRAWINGS

Example embodiments of the disclosure will be more clearly understood from the following detailed description taken in conjunction with the accompanying drawings.

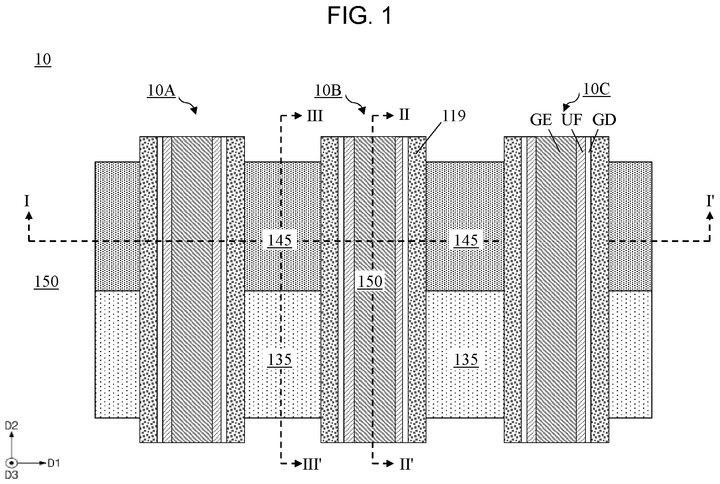

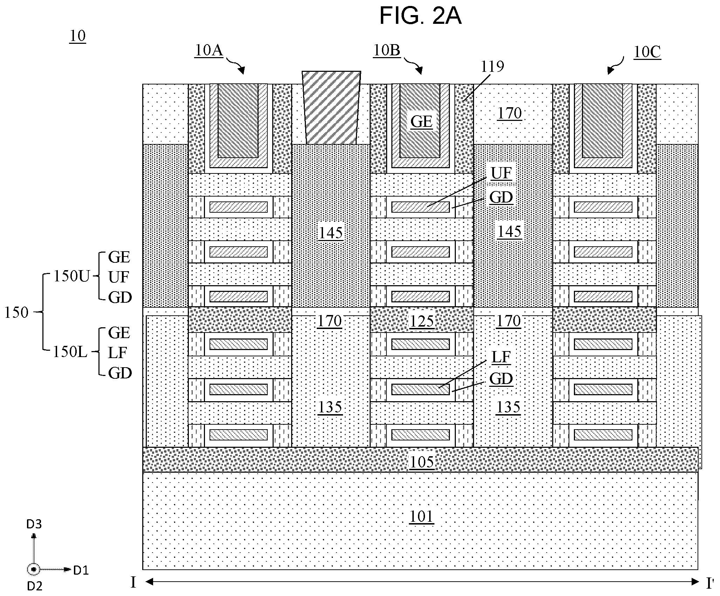

FIGS. 1 and 2A through 2C illustrate a stacked semiconductor device in which source/drain contact structures have different structural characteristics at a lower level for an n-type transistor and an upper level for a p-type transistor when channel widths are different at the lower level and the upper level, according to one or more embodiments.

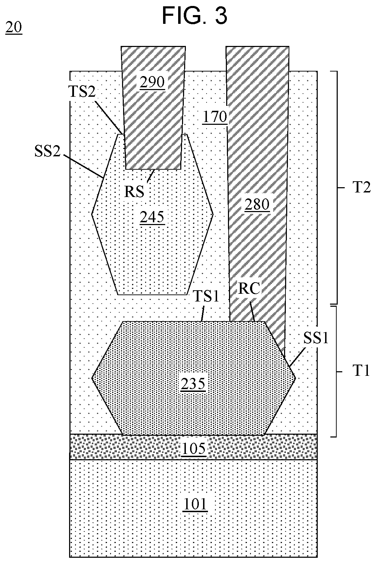

FIG. 3 illustrates a stacked semiconductor device in which source/drain contact structures have different structural characteristics at a lower level for a p-type transistor and an upper level for an n-type transistor when channel widths are different at the lower level and the upper level, according to one or more other embodiments.

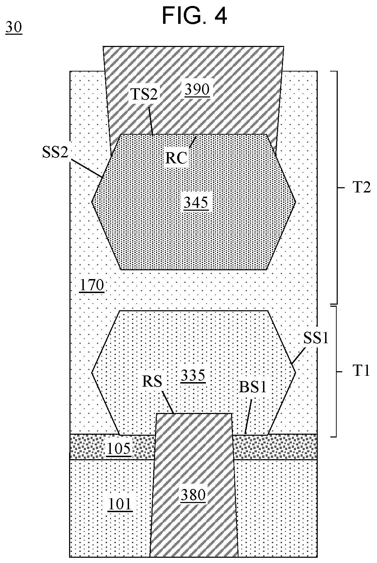

FIG. 4 illustrates a stacked semiconductor device in which source/drain contact structures have different structural characteristics at a lower level for an n-type transistor and an upper level for a p-type when channel widths are the same at the lower level and the upper level, according to still one or more other embodiments.

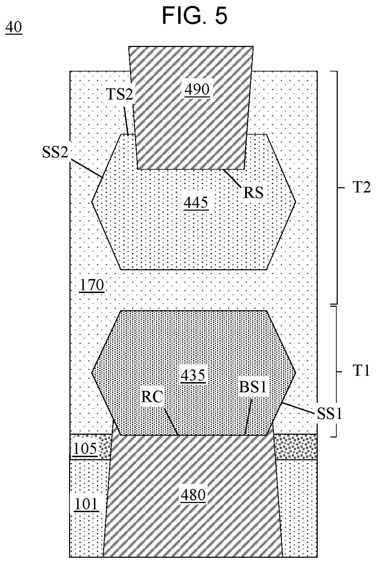

FIG. 5 illustrates a stacked semiconductor device in which source/drain contact structures have different structural characteristics at a lower level for a p-type transistor and an upper level for an n-type when channel widths are the same at the lower level and the upper level, according to still one or more other embodiments.

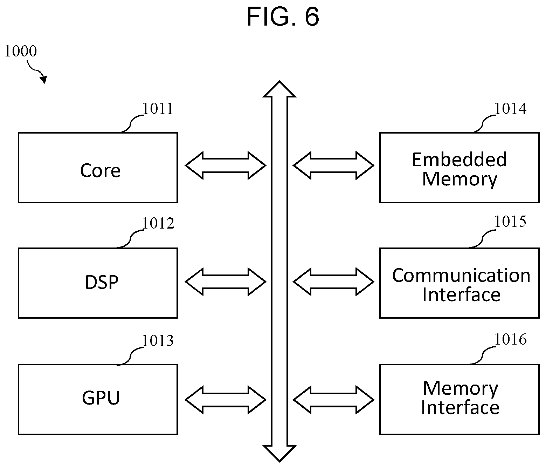

FIG. 6 is a schematic block diagram illustrating an electronic device including a stacked semiconductor device in which source/drain contact structures have different structural characteristics at a lower level and an upper level, according to one or more embodiments.

### DETAILED DESCRIPTION

All of the embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element of the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, elements referred to as a "left" element and a "right" element" may be a "right" element and a "left" element when a device or structure including these elements are differently oriented. Thus, herein, a "left" element and a "right" element of a structure may also be referred to as a "1^{st}" element and a "2^{nd}" element, respectively, of the structure as long as their structural relationship is clearly understood in the context of the descriptions.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element described in the descriptions of an embodiments could be termed a 2^{nd} element in the descriptions of another element or one or more claims, and vice versa without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c.

In the descriptions herein, the terms of degree including "substantially" or "about" may be used. In one or more examples, when specifying that a parameter X may be substantially the same as parameter Y, the term "substantially" may be understood as X being within 10% of Y. In one or more examples, when specifying that a parameter is about X, the term "about" may be understood as being within 10% of X. Still, when a term "same" is used to compare parameters of two or more elements, the term may cover "substantially same" parameters.

It will be understood that, when the term "contact" is used to describe two metal elements, for example, a metal line and a via structure, a barrier metal layer such as titanium (Ti), tantalum (Ta), titanium nitride (TiN), tantalum nitride (TaN), tungsten nitride (WN), nickel nitride (NiN), cobalt nitride (CoN), or platinum nitride (PtN), not being limited thereto, may be formed therebetween. The barrier metal layer may also be formed between the metal line or the via structure and an isolation structure such as a dielectric layer. The purposes of forming the barrier metal layer include improvement of adhesion performance and prevention of metal diffusion into the isolation structure. Further, it will be understood that, when a metal contract structure is described as being formed on or contact a surface of a source/drain pattern, a silicide layer such as cobalt silicide (CoSi₂), nickel silicide (NiSi₂), titanium silicide (TiSi₂), or tungsten silicide (WSi₂), not being limited thereto, may be formed therebetween to improve connection performance therebetween.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

FIGS. 1 and 2A through 2C illustrate a stacked semiconductor device in which source/drain contact structures have different structural characteristics at a lower level for an n-type transistor and an upper level for a p-type transistor when channel widths are different at the lower lever and the upper level, according to one or more embodiments.

FIG. 1 is a plan view of a stacked semiconductor device 10 and FIGS. 2A through 2C are cross-section views of the stacked semiconductor device 10 shown in FIG. 1 taken along lines I-I', II-II' and III-III', respectively. It is to be understood here that FIG. 1 is provided to show a positional relationship between gate structures and source/drain patterns, and thus, some structural elements such as an interlayer isolation structure, contact structures, etc. shown in FIGS. 2A through 2C are omitted in FIG. 1 for brevity purposes.

As shown in FIG. 1, a 1^{st} direction D1 is a channel-length direction in which current flows between two source/drain patterns connected to each other through a channel structure, a 2^{nd} direction D2 is a channel-width direction or a cell-height direction that horizontally intersects the 1^{st} direction D1, and a 3^{rd} direction D3 is a channel-thickness direction that vertically intersects the 1^{st} direction D1 and the 2^{nd} direction D2. The 1^{st} direction D1 and the 2^{nd} direction D2 are referred to as horizontal directions, and the 3^{rd} direction D3 is referred to as a vertical direction.

Referring to FIG. 1 and FIGS 2A through 2C, the stacked semiconductor device 10 may include a 1^{st} channel stack 10A, a 2^{nd} channel stack 10B and a 3^{rd} channel stack 10C, each of which includes a lower channel structure formed of a plurality of lower channel layers 110 and an upper channel structure formed of a plurality of upper channel layers 120 vertically above the lower channel structure. The lower channel structure may be formed at a lower level on a base layer 101, and the upper channel structure may be formed at an upper level above the lower level. These channel layers 110 and 120 may be epitaxially grown from the base layer 101 which may be a silicon-based substrate. Between the two channel structures may be formed a middle isolation layer 125 which isolates the two channel structures from each other. Further, a bottom isolation layer 105 may be formed on a top surface of the base layer 101 to extend in the 1^{st} direction D1 to isolate the base layer 101 from active structures of the stacked semiconductor device 10 including the channel stacks 10A-10C.

The lower channel layers 110 may connect lower source/drain patterns 135 at both sides thereof to each other so that current can flow therebetween at a control of a lower gate structure 150L which surrounds the lower channel layers 110. Similarly, the upper channel layers 120 may connect upper source/drain patterns 145 at both sides thereof to each other so that current can flow therebetween at a control of an upper gate structure 150U which surrounds the upper channel layers 120. The lower gate structure 150L and the upper gate structure 150U form a gate structure 150 of the stacked semiconductor device 10. The lower source/drain patterns 135 may be epitaxially grown from the lower channel layers 110 of the lower channel structure in the channel stacks 10A-10C, and the upper source/drain patterns 145 may be epitaxially grown from the upper channel layers 120 of the upper channel structure in the channel stacks 10A-10C. The gate structure 150 may be formed by replacing a dummy gate structure and a plurality of sacrificial layers in a process of manufacturing the stacked semiconductor device 10.

Thus, in the stacked semiconductor device 10, the lower channel layers 110 along with the lower source/drain patterns 135 at both sides thereof and the lower gate structure 150L surrounding these lower channel layers 110 may form a lower transistor T1, which is a nanosheet transistor, at the lower level. Further, the upper channel layers 120 along with the upper source/drain patterns 145 at both sides thereof and the upper gate structure 150U surrounding these upper channel layers 120 may form an upper transistor T2, which is also a nanosheet transistor, at the upper level.

The base layer 101 as a substrate may be formed of silicon (Si). Additionally, or alternatively, it may include other materials such as silicon germanium (SiGe), silicon carbide (SiC), not being limited thereto. The lower source/drain patterns 135 and the upper source/drain patterns 145 may each be formed of silicon (Si) or silicon germanium (SiGe). For example, the lower source/drain patterns 135 may be formed of Si while the upper source/drain patterns 145 may be formed of SiGe. Further, the lower source/drain patterns 135 may be doped with n-type impurities such as phosphorus (P), arsenic (As), antimony (Sb), etc. while the upper source/drain patterns 145 may be doped with impurities such as boron (B), gallium (Ga), indium (In), etc. In this example, the lower transistor T1 may form an n-type field-effect transistor, and the upper transistor T2 may form a p-type field-effect transistor. Herein, the stacked semiconductor device 10 shown in FIGS. 1 and 2A through 2C is formed of the n-type lower transistor T1 and the p-type upper transistor T2 as an example. The materials forming the source/drain patterns 135 and 145 will be described later in more detail.

The lower gate structure 150L of the lower transistor T1 may include a gate dielectric layer GD, a lower work-function metal layer LF and a gate electrode GE, and the upper gate structure 150U may include the gate dielectric layer GD, an upper work-function metal layer UF and the gate electrode GE.

The gate dielectric layer GD may include an interfacial layer and a high-k dielectric layer formed on the interfacial layer. The interfacial layer may be formed on each of the channel layers 110 and 120 to protect the channel layers 110 and 120 and facilitate growth of the high-k dielectric layer thereon, and the high-k dielectric layer may be formed on the interfacial layer to allow an increased gate capacitance without associated current leakage from the gate structure 150. For these purposes, the interfacial layer may be formed of an oxide material such as silicon oxide (SiO or SiO₂) and/or silicon oxynitride (SiON), not being limited thereto, and the high-k dielectric layer may be formed of a high-k material such as hafnium oxide (HfO₂), hafnium silicate (HfSiO₄), titanium oxide (TiO₂), zirconium oxide (ZrO₂), aluminum oxide (Al₂O₃), lanthanum oxide (La₂O₃), yttrium oxide (Y₂O₃), etc.

The lower work-function metal layer LF may formed on the gate dielectric layer GD surrounding the lower channel layers 110 to control a gate threshold voltage for the lower transistor T1, and the upper work-function metal layer UF may formed on the gate dielectric layer GD surrounding the upper channel layers 120 to control a gate threshold voltage for the upper transistor T2. Each of the work-function metal layers LF and UF may be formed of metal such as Ti, Ta, Al, W, TiN, WN, TiAl, TiAlN, TaN, TiC, TaC, TiAlC, TaCN, TaSiN, and/or a combination thereof, not being limited thereto. However, the lower work-function metal layer LF for the lower transistor T1 and the upper work-function metal layer UF for the upper transistor T2 may be formed of different materials when the two transistors are of different polarity types, i.e., n-type and p-type, respectively. For example, as the lower transistor T1 is of n-type and the upper transistor T2 is of p-type, the lower work-function metal layer LF may be formed of Al or TiC, and the upper work-function metal layer UF may be formed of TiN.

Although the two transistors T1 and T2 have different work-function metal layers LF and UF, respectively, the same gate electrode GE may surround the two work-function metal layers LF and UF to form the two transistors T1 and T2 as a complementary metal-oxide-semiconductor (CMOS) device, e.g., an inverter circuit. The gate electrode GE may be formed of a metal such as Cu, W, Al, Ru, Mo, Co, etc., or a metal alloy thereof. However, the disclosure is not limited thereto, and a gate isolation layer or structure may be formed to separate the gate structure 150 into two gate structures for the respective two transistors T1 and T2. For example, a gate electrode on the lower work-function metal layer LF may be isolated from a gate electrode on the upper work-function metal layer UF.

An interlayer isolation structure 170 may be formed to surround the source/drain patterns 135 and 145 to isolate these semiconductor structures from each other and other circuit elements. The interlayer isolation structure 170 may be formed of a low-k dielectric material such as silicon oxide (e.g., SiO₂).

Gate spacers 119 may be respectively formed on a left side surface and a right side surface of an upper portion of the gate structure 150 disposed above the uppermost upper channel layer 120 in each of the channel stacks 10A-10C. For example, the gate spacers 119 may be respectively formed on a left side surface and a right side surface of the gate dielectric layer included in the upper portion of the gate structure 150 in each of the channel stacks 10A-10C. Thus, the gate spacers 119 may also laterally face the upper source/drain patterns 145 and/or a portion of the interlayer isolation structure 170 formed vertically above the upper source/drain patterns 145.

The gate spacers 119 may be used to protect a dummy gate structure formed of polycrystalline silicon (p-Si) or amorphous silicon (a-Si) from various processes performed in manufacturing the 3D-stacked semiconductor device 10, and remain after the dummy gate structure is replaced by the gate structure 150 to prevent current leakage therefrom to other circuit elements. The gate spacer 119 may be formed of silicon nitride (e.g., SiN or Si₃N₄), SiBCN, SiCN, SiOC, SiOCN, silicon oxide (e.g., SiO₂), etc., not being limited thereto.

Inner spacers 103 may be formed between the lower source/drain pattern 135 and the lower work-function metal layer LF and between the upper source/drain pattern 145 and the upperwork-function metal layer UF to isolate these structural elements from each other. The inner spacers 103 may be formed of silicon nitride (e.g., SiN or Si₃N₄), not being limited thereto.

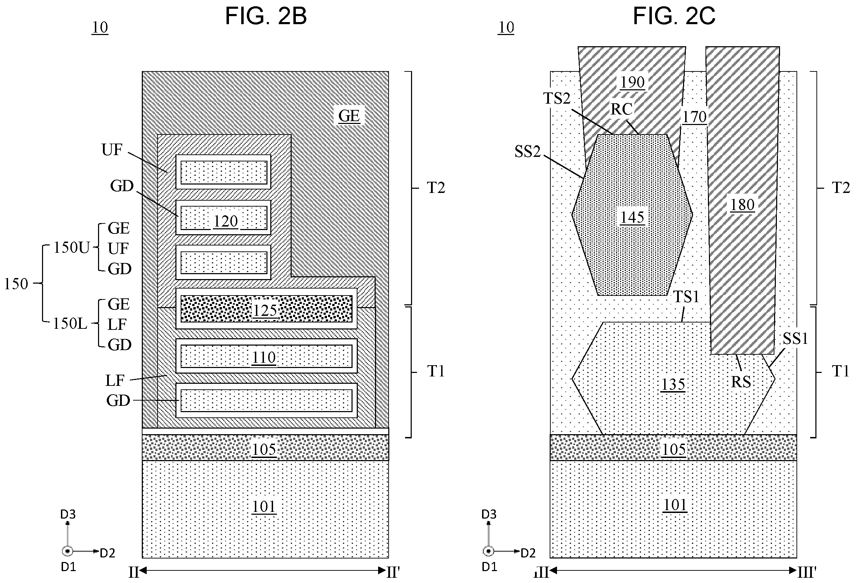

In the stacked semiconductor device 10 as shown in FIGS. 1 and 2B, the upper channel structure including the upper channel layers 120 may have a smaller width in the 2^{nd} direction D2 than the lower channel structure including the lower channel layers 110, and the upper channel layers 120 may only partially overlap the lower channel layer 110 in the 3^{rd} direction D3. For example, left side surfaces of the channel layers 110 and 120 may be aligned or coplanar with each other in the 3^{rd} direction D3, while right side surfaces thereof are not. Thus, as shown in FIG. 2C, the upper source/drain patterns 145 epitaxially grown from the upper channel layers 120 may also be formed to have a smaller width in the 2^{nd} direction D2 than the lower source/drain patterns 135 epitaxially grown from the lower channel layers 110, and a right portion of the lower source/drain pattern 135 may not be overlapped by the upper source/drain pattern 145 in the 3^{rd} direction D3.

Due to this width difference between the lower source/drain pattern 135 and the upper source/drain pattern 145, a lower contact structure (or lower contact plug) 180 may be formed on a top surface TS1 of the lower source/drain pattern 135 which is not overlapped by the upper source/drain pattern 145 in the D3 direction. This lower contact structure 180 may vertically extend upward in the 3^{rd} direction D3 through a region in the interlayer isolation structure 170, where the upper source/drain pattern 145 is not formed, to connect the lower source/drain pattern 135 to a voltage source or another circuit element for signal routing purposes. The lower contact structure 180 may also formed on a right side surface SS1 of the lower source/drain pattern 135 when the top surface TS1 of the lower source/drain pattern 135 which is not overlapped by the upper source/drain pattern 145 does not provide an enough area for formation of the lower contact structure 180. In contrast, an upper contact structure (or upper contact plug) 190 may be formed on a top surface TS2 of the upper source/drain pattern 145 to connect the upper source/drain pattern 145 to a voltage source or another circuit element for signal routing purposes.

The foregoing characteristics of the channel structures and the source/drain patterns may be provided to address increasing demands for a high device density in a semiconductor device including the stacked semiconductor device 10.

The upper channel structure forming the upper transistor T2 may have a greater number of channel layers than that of the lower channel structure forming the lower transistor T1 such that the two transistors may have the same or substantially same effective channel width (W_{eff}). For example, the upper channel structure may have three channel layers while the lower channel structure have two channel layers as shown in FIGS. 2A and 2B.

The different channel widths and the different number of channel layers may facilitate optimization of a stacked semiconductor device in terms of not only an area gain for a high-density semiconductor device but also device performance such as current speed, work load distribution, power efficiency, contact resistance, thermal control, structural stability, etc.

The device performance of the stacked semiconductor device 10 may also be improved by controlling a stress (or strain) applied to the channel layers 110 and 120 by the source/drain patterns 135 and 145. For example, the source/drain patterns 135 and 145 may be configured to apply a channel stress to the channel layers 110 and 120 to boost carrier (hole or electron) mobility, thereby to drive current increase through the channel layers 110 and 120.

For this purpose, the lower source/drain patterns 135 of n-type may be formed of silicon (Si) and/or silicon carbide (SiC) while the upper source/drain patterns 145 of p-type may be formed of silicon germanium (SiGe). As SiGe has a greater lattice constant or size than Si or SiC, the upper source/drain patterns 145 of p-type including SiGe may apply a compressive stress (or compressive strain) to the upper channel layers 120 to boost hole mobility therethrough, while the lower source/drain patterns 135 of n-type including Si and/or SiC may apply a tensile stress (or tensile strain) to the lower channel layers 110 to boost electron mobility therethrough. Further, the p-type impurities or dopants such as boron (B), gallium (Ga), indium (In), etc. in the upper source/drain patterns 145 of SiGe may enhance the compressive stress in the upper channel layers 120, and the n-type impurities or dopants such as phosphorus (P), arsenic (As), antimony (Sb), etc. in the lower source/drain patterns 135 may enhance the tensile stress in the lower channel layers 110.

In the meantime, the formation of the lower contact structure 180 and the upper contact structure 190 may also affect the channel stress control by the source/drain patterns 135 and 145. The contact structures 180 and 190 may be formed of a metal such as Cu, W, Al, Ru, Mo, Co, etc., or a metal alloy thereof.

As shown in FIG. 2C, the lower contact structure 180 may be formed such that a lower portion of the lower contact structure 180 is formed in a recess RS formed on or across a top surface TS1 and a right side surface SS1 of the lower source/drain pattern 135 which is not vertically overlapped by the upper source/drain pattern 145. This recess RS on the lower source/drain pattern 135 may be formed by an etching operation on the top surface TS1 and the right side surface SS1 of the lower source/drain pattern 135 through the interlayer isolation structure 170. Thus, the lower contact structure 180 may take a form of being inserted in or penetrating into the top surface TS1 and the right side surface SS1 of the lower source/drain pattern 135. By forming the lower source/drain pattern 135 and the lower contact structure 180 in this manner, a volume of the lower source/drain pattern 135 may be reduced to increase the tensile stress applied to the lower channel layers 110 because a smaller volume of the lower source/drain pattern 135 of Si and/or SiC causes a mechanical force applied to the lower channel layers 110 to be more concentrated, thereby increasing the tensile stress on the lower channel layers 110.

Also as shown in FIG. 2C, the upper contact structure 190 may be formed such that a lower portion of the upper contact structure 190 wraps an upper portion of the upper source/drain pattern 145 including at least a portion of a top surface TS2 and/or at least a portion of a side surface SS2 so that a volume of the upper source/drain pattern 145 is not lost or reduced. Thus, the upper portion of the upper source/drain pattern 145 may take a form of being formed in a recess RC on a bottom surface of the upper contact structure 190. By forming the upper source/drain pattern 145 and the upper contact structure 190 in this manner, a volume of the upper source/drain pattern 145 may not be lost or may be maintained to increase the compressive stress applied to the upper channel layers 120 because a larger volume of the upper source/drain pattern 145 of SiGe having a relatively greater lattice constant or size provides a greater mechanical force, thereby increasing the compressive stress on the upper channel layers 120.

In the above embodiments, improvement of device performance in terms of channel stress is achieved when a stacked semiconductor device is formed of n-type lower source/drain patterns of Si and/or SiC and p-type upper source/drain patterns of SiGe, and further, the lower source/drain patterns have a greater width based on a lower channel structure having a greater width and a smaller number of channel layers, and the upper source/drain patterns have a smaller width based on an upper channel structure having a smaller width and a greater number of channel layers. However, the disclosure is not limited thereto as described below.

FIG. 3 illustrates a stacked semiconductor device in which source/drain contact structures have different structural characteristics at a lower level for a p-type transistor and an upper level for an n-type transistor when channel widths are different at the lower lever and the upper level, according to one or more other embodiments.

Referring to FIG. 3, which corresponds to FIG. 2C, a stacked semiconductor device 20 may have the same structural elements included in the stacked semiconductor device 10 of FIGS. 1 and 2A-2C, except that polarities of a lower transistor T1 and an upper transistor T2 are reversed in the stacked semiconductor device 20. Herebelow, only different aspects of the stacked semiconductor device 20 are described while duplicate descriptions thereof may be omitted.

In the stacked semiconductor device 20, the lower transistor T1 may be formed of lower source/drain patterns 235 of p-type and the upper transistor T2 may be formed of upper source/drain patterns 245 of n-type. Thus, the lower source/drain patterns 235 may be formed of SiGe with p-type impurities, and the upper source/drain patterns 245 may be formed of Si and/or SiC with n-type impurities. Further, the lower source/drain patterns 235 may be formed to apply a compressive stress to the lower channel layers 110, and the upper source/drain patterns 245 may be formed to apply a tensile stress to the upper channel layers 120.

In addition, as shown in FIG. 3, a lower contact structure 280 may be formed such that a lower portion of the lower contact structure 280 wraps a portion of the lower source/drain pattern 235 including at least a portion of a top surface TS1 and/or at least a portion of a side surface SS1, which is not vertically overlapped by the upper source/drain pattern 245, so that a volume of the lower source/drain pattern 235 is not lost or reduced by the lower contact structure 280. Thus, a portion, for example, an upper-right portion, of the lower source/drain pattern 235 may take a form of being formed in a recess RC on a bottom surface of the lower contact structure 280. By forming the lower source/drain pattern 235 and the lower contact structure 280 in this manner, the compressive stress applied to the lower channel layers 110 may be increased.

In contrast, also as shown in FIG. 3, an upper contact structure 290 may be formed such that a lower portion of the upper contact structure 290 is formed in a recess RS formed on at least a top surface TS2 of the upper source/drain pattern 245. Thus, the upper contact structure 290 may take a form being inserted in or penetrating into the top surface TS2 of the upper source/drain pattern 245. By forming the upper source/drain pattern 245 and the upper contact structure 290 in this manner, the tensile stress applied to the upper channel layers 120 may be increased.

Thus, a stacked semiconductor device formed of p-type lower source/drain patterns with a greater width and n-type upper source/drain patterns with a smaller width may also have an improved device performance in terms of channel stress based on the formation of the source/drain patterns and the contact structures.

FIG. 4 illustrates a stacked semiconductor device in which source/drain contact structures have different structural characteristics at a lower level for an n-type transistor and an upper level for a p-type when channel widths are the same at the lower lever and the upper level, according to still one or more other embodiments.

Referring to FIG. 4, which corresponds to FIG. 2C, a stacked semiconductor device 30 may have the same structural elements included in the stacked semiconductor device 10 of FIGS. 1 and 2A-2C, except that lower source/drain patterns 335 and the upper source/drain patterns 345 have the same or substantially same width in the 2^{nd} direction D2. Herebelow, only different aspects of the stacked semiconductor device 30 are described while duplicate descriptions thereof may be omitted.

The same or substantially same source/drain pattern width for a lower transistor T1 and an upper transistor T2 in the stacked semiconductor device 30 may be obtained by forming the lower channel layers 110 and the upper channel layers 120 to have the same or substantially same width and the same number of channel layers because the lower source/drain patterns 335 and the upper source/drain patterns 345 are epitaxially grown from the lower channel layers 110 and the upper channel layers 120, respectively, as described earlier with respect to the stacked semiconductor device 10.

When the lower source/drain pattern 335 and the upper source/drain pattern 345 vertically thereabove have the same or substantially same width, a lower contact structure for the lower source/drain pattern 335 may not be formed on a top surface of the lower source/drain pattern 335 as in the stacked semiconductor device 10 unless an additional space is provided for the stacked semiconductor device 30 and the lower contact structure formed in the additional space is bent to contact the top surface of the lower source/drain pattern 335. However, the lower contact structure may be formed as backside contact structure 380 on a back side of the stacked semiconductor device 30 as shown in FIG. 4. The backside contact structure 380 may be formed to penetrate the base layer101 and the bottom isolation layer 105 to contact a bottom surface BS1 of the lower source/drain pattern 335. Since the lower source/drain pattern 335 is of n-type formed of Si and/or SiC with n-type impurities, the lower source/drain pattern 335 and the backside contact structure 380 may be formed such that a recess RS is formed on the bottom surface BS1 of the lower source/drain pattern 335 to reduce a volume of the lower source/drain pattern 335 and an upper portion of the backside contact structure 380 is formed in the recess RS. Thus, the tensile stress applied to the lower channel layers 110 may be increased.

In contrast, an upper contact structure 390 may be formed such that a lower portion of the upper contact structure 390 wraps an upper portion of the upper source/drain pattern 245 including at least a portion of a top surface TS2 and/or at least a portion of a side surface SS2 so that a volume of the upper source/drain pattern 345 is not lost or reduced by the upper contact structure 390. Thus, a portion, for example, an upper portion, of the upper source/drain pattern 345 may take a form of being formed in a recess RC formed on a bottom surface of the upper contact structure 390. By forming the upper source/drain pattern 345 and the upper contact structure 390 in this manner, the compressive stress applied to the upper channel layers 120 may be increased.

Thus, a stacked semiconductor device formed of n-type lower source/drain patterns and p-type upper source/drain patterns having the same or substantially same width may also have an improved device performance in terms of channel stress based on the formation of the source/drain patterns and the contact structures.

FIG. 5 illustrates a stacked semiconductor device in which source/drain contact structures have different structural characteristics at a lower level for a p-type transistor and an upper level for an n-type when channel widths are the same at the lower lever and the upper level, according to still one or more other embodiments.

Referring to FIG. 5, which corresponds to FIG. 4, a stacked semiconductor device 40 may have the same structural elements included in the stacked semiconductor device 30 of FIG. 4, except that polarities of a lower transistor T1 and an upper transistor T2 are reversed in the stacked semiconductor device 40. Herebelow, only different aspects of the stacked semiconductor device 20 are described while duplicate descriptions thereof may be omitted.

In the stacked semiconductor device 40, since a lower source/drain pattern 435 is of p-type formed of SiGe with p-type impurities, the lower source/drain pattern 435 and a backside contact structure 480 may be formed such that an upper portion of the backside contact structure 480 wraps a lower portion of the upper source/drain pattern 245 including at least a portion of a bottom surface BS1 and/or at least a portion of a side surface SS1 so that a volume of the lower source/drain pattern 435 is not lost or reduced by the backside contact structure 480. Thus, a portion, for example, a lower portion, of the lower source/drain pattern 435 may take a form of being formed in a recess RC on a top surface of the backside contact structure 480. By forming the lower source/drain pattern 435 and the backside contact structure 480 in this manner, the compressive stress applied to the lower channel layers 110 may be increased.

In contrast, since an upper source/drain pattern 445 is of n-type formed of Si and/or SiC with n-type impurities, the upper source/drain pattern 445 and the upper contact structure 490 may be formed such that a recess RS is formed on a top surface TS2 of the upper source/drain pattern 445 to reduce a volume of the upper source/drain pattern 445 and a lower portion of the upper contact structure 490 is formed in the recess RS. Thus, the tensile stress on the upper channel layers 120 may be increased.

Thus, a stacked semiconductor device formed of p-type lower source/drain patterns and n-type upper source/drain patterns having the same or substantially same width may also have an improved device performance in terms of channel stress based on the formation of the source/drain patterns and the contact structures.

In the above embodiments, when each of the contact structures is formed on a surface of the source/drain patterns, a silicide layer may be formed therebetween to improve device performance, as described earlier.

In the above embodiments, each of the lower transistor T1 and the upper transistor T2 is described as a nanosheet transistor. However, the disclosure is not limited thereto. These transistors T1 and T2 may each be a different type of field-effect transistor such as FinFET or forksheet transistor according to one or more other embodiments.

FIG. 6 is a schematic block diagram illustrating an electronic device including a stacked semiconductor device including different source/drain contact structures, according to one or more embodiments. This stacked semiconductor device included in the electronic device may be or correspond to the stacked semiconductor device 10, 20, 30 or 40 shown in FIGS. 1, 2A-2C, 3, 4 and 5.

Referring to FIG. 6, an SoC 1000 may be an integrated circuit in which components of a computing system or other electronic systems are integrated. As an example of the SoC 1000, an application processor (AP) may include at least one processor and components for various functions. The SoC 1000 may include a core 1011 (e.g., a processor), a digital signal processor (DSP) 1012, a graphic processing unit (GPU) 1013, an embedded memory 1014, a communication interface 1015, and a memory interface 1016. The components of the SoC 1000 may communicate with each other through a bus.

The core 1011 may process instructions and control operations of the components included in the SoC 1000. For example, the core 1011 may process a series of instructions to run an operating system and execute applications on the operating system. The DSP 1012 may generate useful data by processing digital signals (e.g., a digital signal provided from the communication interface 1015). The GPU 1013 may generate data for an image output by a display device from image data provided from the embedded memory 1014 or the memory interface 1016, or may encode the image data.

The embedded memory 1014 may store data necessary for the core 1011, the DSP 1012, and the GPU 1013 to operate. The communication interface 1015 may provide an interface for a communication network or one-to-one communication. The memory interface 1016 may provide an interface for an external memory of the SoC 1000, such as a dynamic random access memory (RAM) (DRAM), a flash memory, etc.

At least one of the core 1011, the DSP 1012, the GPU 1013, and/or the embedded memory 1014 may include the stacked semiconductor device 10, 20, 30 or 40 shown in FIGS.1, 2A-2C, 3, 4 and 5.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A stacked semiconductor device comprising:
a 1^{st} source/drain pattern at a 1^{st} level;
a 2^{nd} source/drain pattern at a 2^{nd} level vertically different from the 1^{st} level; and
a 1^{st} contact structure on the 1^{st} source/drain pattern,
wherein a portion of the 1^{st} source/drain pattern is in a 1^{st} recess of the 1^{st} contact structure.

2. The stacked semiconductor device of claim 1, further comprising a 2^{nd} contact structure on the 2^{nd} source/drain pattern,
wherein a portion of the 2^{nd} contact structure is in a 2^{nd} recess on the 2^{nd} source/drain pattern.

3. The stacked semiconductor device of claim 2, wherein the 2^{nd} recess is on a top surface of the 2^{nd} source/drain pattern.

4. The stacked semiconductor device of claim 3, wherein the 2^{nd} recess is also on a side surface of the 2^{nd} source/drain pattern.

5. The stacked semiconductor device of claim 2, wherein the 2^{nd} recess is on a bottom surface of the 2^{nd} source/drain pattern.

6. The stacked semiconductor device of any one of the preceding claims, wherein the 1^{st} source/drain pattern is of p-type and the 2^{nd} source/drain pattern is of n-type.

7. The stacked semiconductor device of any one of the preceding claims, wherein the 1^{st} source/drain pattern is vertically below the 2^{nd} source/drain pattern.

8. The stacked semiconductor device of any one of claims 1 to 6, wherein the 1^{st} source/drain pattern is vertically above the 2^{nd} source/drain pattern.

9. The stacked semiconductor device of any one of the preceding claims, wherein the 1^{st} source/drain pattern has a greater width than the 2^{nd} source/drain pattern.

10. The stacked semiconductor device of any one of the preceding claim, wherein the 1^{st} source/drain pattern has a greater height than the 2^{nd} source/drain pattern.

11. The stacked semiconductor device of any one of the preceding claims, wherein the 1^{st} contact structure is on a top surface of the 1^{st} source/drain pattern.

12. A stacked semiconductor device comprising:
a 1^{st} source/drain pattern at a 1^{st} level;
a 2^{nd} source/drain pattern at a 2^{nd} level vertically different from the 1^{st} level; and
a 1^{st} contact structure on the 1^{st} source/drain pattern,
wherein a portion of the 1^{st} contact structure is in a 1^{st} recess on the 1^{st} source/drain pattern.

13. The stacked semiconductor device of claim 12, wherein the 1^{st} recess is on at least one of a top surface and a side surface of the 1^{st} source/drain pattern.

14. The stacked semiconductor device of any one of the preceding claims, wherein the 1^{st} source/drain pattern and the 2^{nd} source/drain pattern have different widths in a channel-width direction.
